# EUROPÄISCHE PATENTSCHRIFT

(11) **EP 2 721 657 B1**
(45) Veröffentlichungstag und Bekanntmachung des Hinweises auf die Patenterteilung: **16.09.2015**
(21) Anmeldenummer: 12716376.4
(22) Anmeldetag: 19.04.2012
(51) Int. Cl.: H01L 41/113, H01L 41/053, H02N 2/18

(54) **RELATIVVERSCHIEBUNG ERLEICHTERNDE OBERFLÄCHEN BEI EAP-GENERATOREN**
SURFACES THAT EASE RELATIVE DISPLACEMENT IN EAP GENERATORS
SURFACES FACILITANT LE DÉPLACEMENT RELATIF DANS DES GÉNÉRATEURS EN POLYMÈRES ÉLECTROACTIFS

(30) Priorität: 16.06.2011 DE 102011077583
(43) Veröffentlichungstag der Anmeldung: 23.04.2014
(73) Patentinhaber: Robert Bosch GmbH, 70442 Stuttgart (DE)
(72) Erfinder: DENES, Istvan, 71336 Waiblinge/Hohenacker (DE)
(86) Internationale Anmeldenummer: PCT/EP2012/057102
(87) Internationale Veröffentlichungsnummer: WO 2012/171681

(56) Entgegenhaltungen:
- WO-A1-2010/011562
- WO-A1-2010/111376
- US-A1- 2010 079 037

## Beschreibung

### Stand der Technik

Die Erzeugung von Energie aus Wellen ist die Umwandlung der Bewegungsenergie von Wellen an der Meeresoberfläche in beispielsweise elektrische Energie. Um die Energie der Meereswellen nutzen zu können, kann die kinetische Energie mit Hilfe der relativen Auslenkung von Schwimmkörpern in eine lineare Bewegung überführt werden. Ein Beispiel ist die als Seeschlange (griechisch: Pelamis) bezeichnete Bauform für Wellenkraftwerke. Diese bestehen aus mehreren Stahlrohrsegmenten, die über Gelenke beweglich miteinander verbunden sind. An den Gelenken sind hydraulische Pumpen befestigt, die einen Generator antreiben. Ein anderes Beispiel sind die so genannten point absorber. Bei ihnen handelt es sich um schwimmende Vorrichtungen mit Komponenten, die sich aufgrund der Wellenbewegung relativ zueinander bewegen, beispielsweise eine Schwimmboje innerhalb eines feststehenden Zylinders. Die Relativbewegung der Komponenten wird genutzt, um elektromechanische oder hydraulische Energiewandler zu betreiben.

Eine Energieumwandlungseinrichtung zur Umwandlung von Wellenenergie wird beispielsweise in der Offenlegungsschrift DE 10 2009 035 928 A1 beschrieben. Diese Umwandlungseinrichtung weist mindestens einen in einem Fluid angeordneten Kopplungskörper auf, welcher dazu eingerichtet ist, an zumindest einer der Wellenbewegung des Fluids zugeordneten Orbitalströmungsbewegung zu koppeln. Ferner weist die Umwandlungseinrichtung eine Führungseinrichtung auf, die eine geführte, endlos umlaufende Orbitalbewegung und/oder Drehbewegung des mindestens einen Kopplungskörpers vorgibt. Dabei weist die Führungseinrichtung einen Antrieb auf, an dem sie die Umlaufbewegung und/oder die Drehbewegung in ein Drehmoment umsetzt.

Elektroaktive Polymere (EAP) sind Polymere, die ihre Form durch das Anlegen einer elektrischen Spannung verändern. Daher werden elektroaktive Polymere als Aktoren oder Sensoren verwendet. Elektroaktive Polymere ermöglichen aber auch einen generatorischen Betrieb, bei dem mechanische Dehnungsenergie direkt in elektrische Energie umgewandelt wird. Derartige Energiewandler werden als EAP-Generatoren bezeichnet. Die Umwandlung der Dehnungsenergie in elektrische Energie erfolgt auf kapazitiver Basis durch Verschieben von Landungen. Bei der Energiegewinnung mittels EAPs wird der EAP-Generator, umfassend mindestens ein Bauelement, das zwei nachgiebige Elektroden umfasst, zwischen denen eine Schicht aus elektroaktivem Polymer angeordnet ist, aufgrund einer äußeren Krafteinwirkung gedehnt. Im Zustand maximaler Dehnung des EAP-Generators wird die Anordnung mit elektrischen Ladungen unterhalb der Durchbruchsfeldstärke beaufschlagt. Bei Verringerung der äußeren Krafteinwirkung relaxiert das EAP wegen der elastischen Wirkung des Polymers. In dieser Phase erhöht sich die im EAP-Generator gespeicherte Energie. Dieser Vorgang stellt die eigentliche Umwandlung der mechanischen in die elektrische Energie dar. Sobald der EAP-Generator vollständig relaxiert ist, wird die Anordnung entladen, wodurch der EAP-Generator wieder seine Ausgangslänge erreicht. Der Energiegewinnungszyklus kann erneut beginnen.

Für EAP-Generatoren können mehrere Lagen, jeweils umfassend zwei Elektroden zwischen denen eine Schicht aus elektroaktivem Polymer angeordnet ist, zu einen EAP-Stapel zusammen gefasst werden. Für die vorliegende Erfindung werden unter dem Begriff EAP-Stapel aber auch Ausführungsformen verstanden, die nur eine Lage aus zwei Elektroden mit einer dazwischen liegenden Schicht aus elektroaktivem Polymer aufweisen. EAP-Stapel im Sinne der vorliegenden Erfindung sind daher Stapel, die mindestens eine Lage, umfassend zwei vorzugsweise flexible Elektroden und eine zwischen den beiden Elektroden angeordnete Schicht aus elektroaktivem Polymer, aufweisen. Für EAP-Generatoren werden der oder mehrere EAP-Stapel zwischen zwei, parallel zueinander angeordneten, Kraft übertragenden Flächen angeordnet, vorzugsweise derart, dass die Lagen des EAP-Stapels parallel zu den Kraft übertragenden Flächen angeordnet sind, siehe beispielsweise WO 2010/111376 A1. Sobald eine Kraft über diese Flächen auf einen EAP-Stapel ausgeübt wird, wird der Stapel in vertikaler Richtung gestaucht, also in der Richtung, die Senkrecht zu den Kraft übertragenden Flächen, dehnt sich aber gleichzeitig in horizontaler Richtung aus, d. h. in der Ebene der Lagen des EAP-Stapels bezogen auf die EAP-Lagen. Die horizontale Ausdehnung eines EAP-Stapels wird durch die Reibungskräfte zwischen den Endflächen des EAP-Stapels und den Kraft übertragenden Flächen an seinen beiden Enden behindert. Dadurch kommt es zu einem Ausbeulen des EAP-Stapels und einer damit verbundenen, nicht optimalen Energieumwandlung.

### Offenbarung der Erfindung

Die Erfindung betrifft EAP-Generatoren, umfassend mindestens einen EAP-Stapel, der zwischen zwei parallel zueinander angeordneten, Kraft übertragenden Flächen angeordnet ist, wobei der EAP-Generator mindestens eine die Relativverschiebung zwischen dem einen Ende des mindestens einen EAP-Stapels und der diesem Ende zugewandten, Kraft übertragenden Fläche erleichternde Schicht zwischen diesem Ende des mindestens einen EAP-Stapels und der diesem Ende zugewandten, Kraft übertragenden Fläche aufweist. Mit dem Begriff Relativverschiebung wird auf die Relativverschiebung Bezug genommen, die zwischen dem zumindest einen EAP-Stapel und der Kraft übertragenden Fläche stattfindet, nämlich zwischen dem einen Ende des zumindest einen EAP-Stapels und der Kraft übertragenden Fläche, die diesem Ende zugewandt ist.

Bei einer Ausführungsform ist die Relativverschiebung erleichternde Schicht zwischen dem zumindest einen EAP-Stapel und der Kraft übertragenden Fläche eine die Reibung verringernde Schicht. Durch den Begriff "Reibung verringernde" wird Bezug auf die Reibung genommen, die zwischen dem einen Ende des EAP-Stapels und der diesem Ende zugewandten, Kraft übertragenden Fläche bei Übertragung einer Kraft auf den EAP-Stapel herrscht, wenn das Ende des EAP-Stapels und die diesem Ende zugewandte, Kraft übertragende Fläche direkt in Kontakt miteinander stehen würden. Die Reibung verringernde Schicht besteht vorzugsweise aus einem anderen Material als die Kraft übertragende Fläche und das Ende des EAP-Stapels zwischen denen die Reibung verringernde Schicht angeordnet ist, und/oder weist andere Oberflächeneigenschaften auf. Die Reibung verringernde Schicht kann eine Flüssigkeit sein oder aus einem Feststoff bestehen. Die Reibung verringernde Schicht kann aus der Gruppe ausgewählt sein, die flüssige Schmierstoffe, zum Beispiel Schmieröle, Schmierfette und Festschmierstoffe wie Grafit enthält.

Sofern die Reibung verringernde Schicht aus einem Feststoff besteht, kann der EAP-Generator zusätzlich ein flüssiges Schmiermittel, beispielsweise ein Schmieröl, auf der Oberfläche der Reibung verringernden Schicht aufweisen, beispielsweise zwischen dem zumindest einen EAP-Stapel und zumindest einer der Kraft übertragenden Flächen. Die Dicke der flüssigen Schmiermittelschicht zwischen einem EAP-Stapel und der Kraft übertragenden Fläche hängt stark von den Normalkräften ab, die auf die einander gegenüberliegenden Flächen des EAP-Stapels und der Kraft übertragenden Fläche einwirken. Wird die Kraft, die von der Kraft übertragenden Fläche auf den EAP-Stapel übertragen wird, über einen bestimmten Wert hinaus erhöht, kann die Flüssigkeit aus dem Spalt zwischen EAP-Stapel und Kraft übertragender Fläche gepresst werden. Das würde zu einer trockenen Reibung zwischen den beiden Flächen führen. Um zu vermeiden dass es zu einer trockenen Reibung zwischen diesen Flächen kommt, kann die Oberfläche der Reibung verringernden Schicht strukturiert sein, sofern es sich bei dieser Schicht um einen Festkörper handelt.

Als Strukturierung ihrer Oberfläche kann die Reibung verringernde Schicht Vertiefungen oder Kammern aufweisen, die mit der Oberfläche in Verbindung stehen. Diese Kammern können aus das Schmiermittel enthalten. Aufgrund der Verbindung der Kammern mit der Oberfläche der Reibung verhindernden Schicht ist der hydrostatischen Druck in den Kammern und zwischen den Flächen gleich. Während der Ausdehnung der EAP-Fläche findet eine Relativverschiebung zwischen der Reibung verringernden Schicht und der Kraft übertragenden Fläche statt. Die Kammern stellen das Schmiermittel für den Spalt zwischen den beiden Flächen bereit, solange das Volumen der Kammern durch die Verformung der Reibung verringernden Schicht, die durch die übertragenen Kräfte verursacht wird, nicht vollständig verschwunden ist.

Bei einer anderen Ausführungsform weist der erfindungsgemäße EAP-Generator eine so genannte Zwischenschicht als die Relativverschiebung erleichternde Schicht auf. Die Zwischenschicht ist stark verformbar. Sie verformt sich, sofern Kraft auf den EAP-Stapel übertragen wird und er sich ausdehnt. Aufgrund der starken Verformbarkeit der Zwischenschicht, können die einschränkenden Kräfte zusammen mit einem Ausbeulen des EAP-Stapels verringert werden.

Das Material, aus dem die Zwischenschicht besteht, kann homogen sein und intrinsische Eigenschaften haben, die die starke Verformbarkeit ermöglichen. Die Zwischenschickt kann jedoch auch in Form eines geschäumten Materials vorliegen, wobei im Wesentlichen die in dem geschäumten Material enthaltenen Hohlräume die Verformbarkeit der Zwischenschickt ermöglichen. Am Ende der Phase, in der sich die mit der übertragenen Kraft beaufschlagte Fläche ausdehnt, weist die Zwischenschicht eine im Wesentlichen trapezförmige Form auf. Sie steht in dieser Phase sowohl mit der Kraft übertragenden Fläche als auch mit der Fläche in Kontakt, die diesem Ende des EAP-Stapels zugewandt ist.

Gemäß einer Ausführungsform weist der EAP-Generator nur an einem Ende des mindestens einen EAP-Stapels eine die Relativverschiebung erleichternde Schicht zwischen dem Ende des EAP-Stapels und der diesem Ende zugewandten, Kraft übertragenden Fläche auf. Bei einer bevorzugten Ausführungsform weist der erfindungsgemäße EAP-Generator an jedem der beiden Enden des bzw. jedes EAP-Stapels eine die Relativverschiebung erleichternde Schicht zwischen dem Ende des EAP-Stapels und der diesem Ende zugewandten, Kraft übertragenden Fläche auf.

Die Relativbewegung erleichternde Schicht kann entweder auf der Fläche des Endes eines EAP-Stapels angeordnet oder befestigt sein. Die Relativverschiebung erleichternde Schicht kann auch auf der Kraft übertragenden Fläche angeordnet oder befestigt sein, vorzugsweise nur in dem Bereich dieser Fläche, die unmittelbar unterhalb und/oder unmittelbar oberhalb eines EAP-Stapels liegt.

Mit den erfindungsgemäßen EAP-Generatoren können unerwünschte Verformungen der EAP-Stapel vermieden werden. Dadurch wird eine effizientere Energieumwandlung in elektrische Energie ermöglicht. Gleichzeitig wird die mechanische Belastung der EAP-Stapel verringert, wodurch sich auch deren Lebendauer verlängert.

Die vorliegende Erfindung erstreckt sich auch auf die Verwendung der erfindungsgemäßen EAP-Generatoren zur Erzeugung elektrischer Energie. Die vorliegende Erfindung umfasst daher auch Verfahren zur Erzeugung elektrischer Energie aus Dehnungsenergie auf kapazitiver Basis durch Verschieben von Ladungen, bei dem die EAP-Stapel eines EAP-Generators, umfassend mindestens einen EAP-Stapel, der zwischen zwei parallel zueinander angeordneten, Kraft übertragenden Flächen angeordnet ist, wobei der EAP-Generator mindestens eine die Relativverschiebung zwischen dem einen Ende des mindestens einen EAP-Stapels und der diesem Ende zugewandten, Kraft übertragenden Fläche erleichternde Schicht zwischen diesem Ende des mindestens einen EAP-Stapels und der diesem Ende zugewandten, Kraft übertragenden Fläche aufweist, indem eine Schicht aus elektroaktivem Polymer aufgrund einer äußeren Krafteinwirkung gedehnt, im Zustand maximaler Dehnung mit elektrischen Ladungen unterhalb der Durchbruchsstärke beaufschlagt, das elektroaktive Polymer relaxiert und die Ladung bei vollständiger Relaxierung der Schicht abgeleitet wird.

Die Erfindung wird nachfolgend mit Bezug auf die Abbildungen und konkreten Ausführungsbeispielen näher erläutert. Hierbei ist zu berücksichtigen, dass weder die Abbildungen noch die zur Erläuterung verwendeten konkreten Ausführungsformen als die Erfindung hierauf beschränkend angesehen werden sollen. Die Erfindung wird ausschließlich durch die Ansprüche bestimmt.

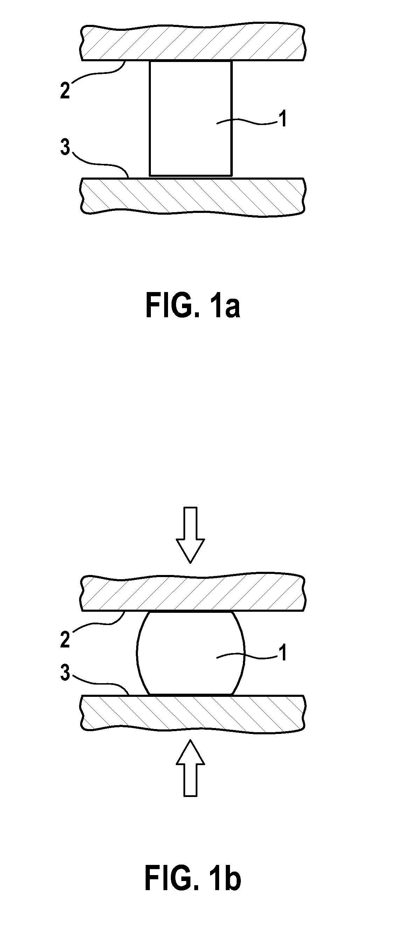

Die Figuren 1 a und 1 b veranschaulichen das der vorliegenden Erfindung zugrunde liegende Problem. Eine EAP-Stapel 1 ist zwischen einer ersten Kraft übertragenden Fläche 2 und einer zweiten Kraft übertragenden Fläche 3, die parallel zur ersten Kraft übertragenden Fläche 2 angeordnet ist, angeordnet. Figur 1a zeigt den EAP-Stapel 1 in relaxiertem Zustand, d.h. in einen Zustand, bei dem keine Kräfte von den Kraft übertragenden Flächen 2, 3 auf den EAP-Stapel 1 übertragen werden. Figur 1b zeigt die in Figur 1a dargestellte Anordnung, wobei die Kraft übertragenden Flächen 2, 3 einander angenähert wurden, so dass Kraft auf den dazwischen liegenden EAP-Stapel 1 übertragen wird. In Folge dessen wird der EAP-Stapel verformt. Er beult sich aus, da er aufgrund der Reibung zwischen seinen, den Kraft übertragenden Flächen zugewandten Flächen und den Kraft übertragenden Flächen sich nicht über seine gesamte Höhe gleichförmig ausdehnen kann.

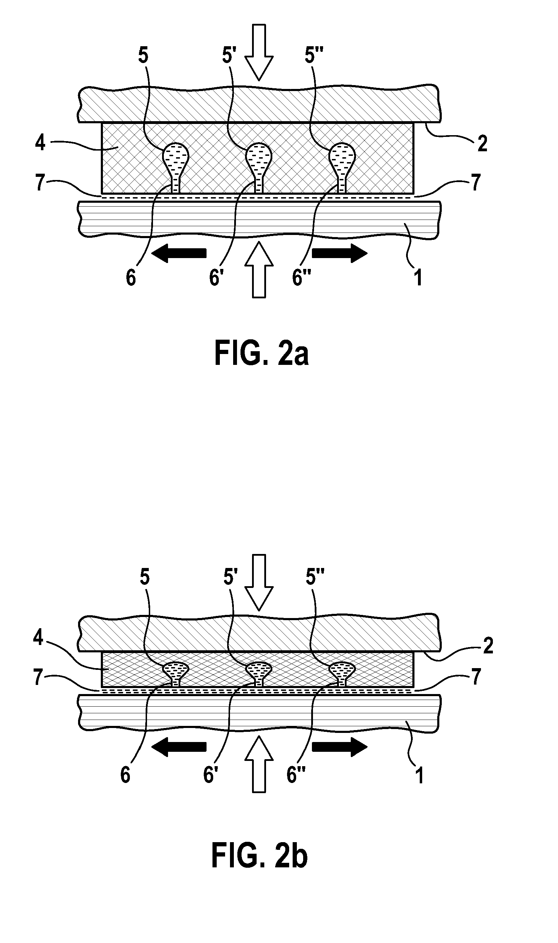

Die Figuren 2a und 2b zeigen eine Ausführungsform, bei der eine die Reibung verringernde Schicht 4 zwischen der Kraft übertragenden Fläche 2 und dem EAP-Stapel 1 angeordnet ist. Die Reibung verringernde Schicht 4 ist an der Fläche 2 befestigt. Die Reibung verringernde Schicht 4 weist Kammern 5, 5' und 5" auf, wobei jede der Kammern 5, 5' und 5" über einen Kanal 6, 6', 6" mit der Oberfläche der Schicht 4 und somit dem Spalt 7 in Verbindung steht. Die Kammern 5, 5' und 5" und der Spalt 7 zwischen der Reibung verringernden Schicht 4 und EAP-Stapel 1 ist mit einem Schmiermittel 8 gefüllt.

Figur 2a zeigt den EAP-Stapel 1 in relaxiertem Zustand, d.h. in einen Zustand, bei dem keine Kräfte von der Kraft übertragenden Fläche 2auf den EAP-Stapel 1 übertragen wird. Figur 2b zeigt die in Figur 2a dargestellte Anordnung in einem Zustand, bei dem Kraft von der Fläche 2 auf den EAP-Stapel 1 übertragen wird. Dabei wird die Reibung verringernde Schicht 4 verformt und das Schmiermittel 8 über Kanäle 6 aus den komprimierten Kammern 5, 5' und 5" in den Spalt 7 gepresst.

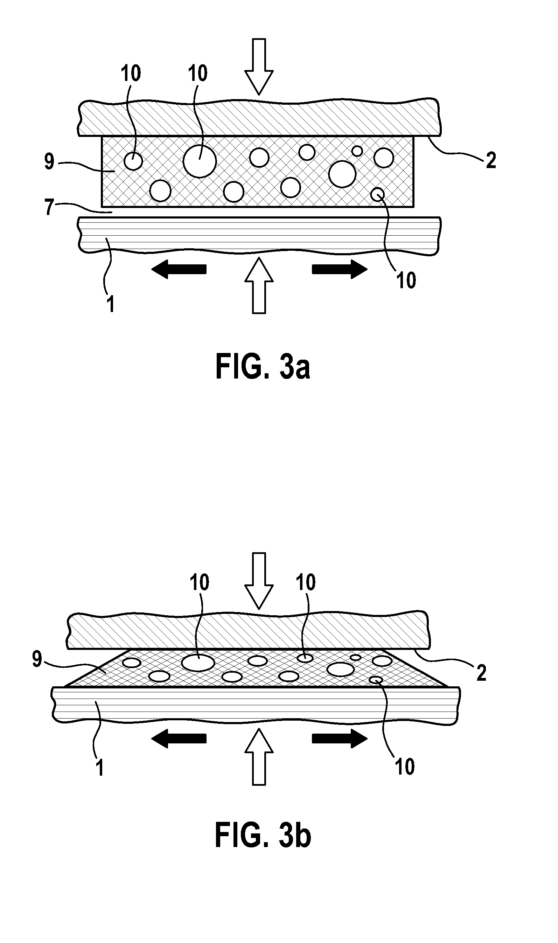

Figuren 3a und 3b zeigen eine alternative Ausführungsform, bei der eine verformbare Zwischenschicht 9 zwischen der Kraft übertragenden Fläche 2 und dem EAP-Stapel 1 angeordnet ist. Die Zwischenschicht 9 ist an der Kraft übertragenden Fläche 2 befestigt. Die Zwischenschicht 4 weist komprimierbare Hohlräume 10 auf.

Figur 3a zeigt den EAP-Stapel 1 in relaxiertem Zustand, d.h. in einen Zustand, bei dem keine Kräfte von der Kraft übertragenden Fläche 2 auf den EAP-Stapel 1 übertragen wird. Figur 3b zeigt die in Figur 3a dargestellte Anordnung in einem Zustand, bei dem Kraft von der Fläche 2 auf den Stapel 1 übertragen wird. Dabei wird die Zwischenschicht 9 zusammengedrückt. Die Hohlräume 10 verformen sich, die Zwischenschicht 9 nimmt Trapezform an.

## Patentansprüche

1. EAP-Generator, umfassend mindestens einen EAP-Stapel (1), der zwischen zwei parallel zueinander angeordneten, Kraft übertragenden Flächen (2, 3) angeordnet ist, **dadurch gekennzeichnet, dass** der EAP-Generator mindestens eine die Relativverschiebung zwischen dem einen Ende des mindestens einen EAP-Stapels (1) und der diesem Ende zugewandten, Kraft übertragenden Fläche (2) erleichternde Schicht (4, 9) zwischen diesem Ende des mindestens einen EAP-Stapels (1) und der diesem Ende zugewandten, Kraft übertragenden Fläche (2) aufweist.

2. EAP-Generator gemäß Anspruch 1, **dadurch gekennzeichnet, dass** die Relativverschiebung erleichternde Schicht (4, 9) eine die Reibung verringernde Schicht (4) ist.

3. EAP-Generator gemäß Anspruch 2, **dadurch gekennzeichnet, dass** die Reibung verringernde Schicht (4) aus einem Festkörper besteht.

4. EAP-Generator gemäß Anspruch 3, **dadurch gekennzeichnet, dass** die Reibung verringernde Schicht (4) eine strukturierte Oberfläche aufweist, vorzugsweise in Form von Kammern (5, 5', 5"), die mit der Oberfläche der Reibung verringernden Schicht (4) in Verbindung stehen.

5. EAP-Generator gemäß Anspruch 3 oder 4, **dadurch gekennzeichnet, dass** er zusätzlich ein flüssiges Schmiermittel (8) auf der Oberfläche der Reibung verringernden Schicht (4) aufweist.

6. EAP-Generator gemäß Anspruch 1, **dadurch gekennzeichnet, dass** er eine Zwischenschicht (4, 9) als die Relativverschiebung erleichternde Schicht aufweist, wobei die Zwischenschicht (4, 9) stark verformbar ist.

7. EAP-Generator gemäß Anspruch 6, **dadurch gekennzeichnet, dass** die Zwischenschicht (4, 9) aus einem homogenen Material besteht, dessen intrinsische Eigenschaften die Verformbarkeit ermöglichen, oder aus einem geschäumten Material.

8. EAP-Generator gemäß einem der vorhergehenden Ansprüche, **dadurch gekennzeichnet, dass** er eine die Relativverschiebung erleichternde Schicht nur an einem Ende des mindestens einen EAP-Stapels (1) aufweist, oder eine die Relativverschiebung erleichternde Schicht (4, 9) an jedem der beiden Enden des mindestens einen EAP-Stapels (1).

9. EAP-Generator gemäß einem der vorhergehenden Ansprüche, **dadurch gekennzeichnet, dass** die Relativbewegung erleichternde Schicht (4, 9) entweder auf der Fläche des Endes eines EAP-Stapels (1) angeordnet oder befestigt ist, oder auf der Kraft übertragenden Fläche (2, 3) angeordnet oder befestigt ist, vorzugsweise nur in dem Bereich der Kraft übertragenden Fläche (2, 3), die unmittelbar unterhalb und/oder unmittelbar oberhalb eines EAP-Stapels (1) liegt.

10. Verfahren zur Erzeugung elektrischer Energie aus Dehnungsenergie auf kapazitiver Basis durch Verschieben von Ladungen, bei dem die EAP-Stapel (1) eines EAP-Generators, umfassend mindestens einen EAP-Stapel (1), der zwischen zwei parallel zueinander angeordneten, Kraft übertragenden Flächen (2, 3) angeordnet ist, wobei der EAP-Generator mindestens eine die Relativverschiebung zwischen dem einen Ende des mindestens einen EAP-Stapels (1) und der diesem Ende zugewandten, Kraft übertragenden Fläche (2, 3) erleichternde Schicht (4,9) zwischen diesem Ende des mindestens einen EAP-Stapels (1) und der diesem Ende zugewandten, Kraft übertragenden Fläche (2) aufweist, indem eine Schicht aus elektroaktivem Polymer aufgrund einer äußeren Krafteinwirkung gedehnt, im Zustand maximaler Dehnung mit elektrischen Ladungen unterhalb der Durchbruchsstärke beaufschlagt, das elektroaktive Polymer relaxiert und die Ladung bei vollständiger Relaxierung der Schicht abgeleitet wird.

## Claims

1. EAP generator, comprising at least one EAP stack (1) which is arranged between two force-transmitting surfaces (2, 3) arranged parallel to one another, **characterized in that**
the EAP generator has at least one layer (4, 9) which facilitates the relative displacement between one end of the at least one EAP stack (1) and the force-transmitting surface (2) facing this end, said layer being situated between this end of the at least one EAP stack (1) and the force-transmitting surface (2) facing this end.

2. EAP generator according to Claim 1, **characterized in that** the layer (4, 9) which facilitates relative displacement is a friction-reducing layer (4).

3. EAP generator according to Claim 2, **characterized in that** the friction-reducing layer (4) consists of a solid.

4. EAP generator according to Claim 3, **characterized in that** the friction-reducing layer (4) has a structured surface, preferably in the form of chambers (5, 5', 5') which are in communication with the surface of the friction-reducing layer (4).

5. EAP generator according to Claim 3 or 4, **characterized in that** it additionally has a liquid lubricant (8) on the surface of the friction-reducing layer (4).

6. EAP generator according to Claim 1, **characterized in that** it has an intermediate layer (4, 9) as the layer which facilitates relative displacement, wherein the intermediate layer (4, 9) is highly deformable.

7. EAP generator according to Claim 6, **characterized in that** the intermediate layer (4, 9) consists of a homogeneous material whose intrinsic properties enable deformability, or of a foamed material.

8. EAP generator according to one of the preceding claims, **characterized in that** it has a layer which facilitates the relative displacement only at one end of the at least one EAP stack (1), or a layer (4, 9) which facilitates the relative displacement at each of the two ends of the at least one EAP stack (1).

9. EAP generator according to one of the preceding claims, **characterized in that** the layer (4, 9) which facilitates relative movement is arranged or fastened either on the surface of the end of an EAP stack (1), or is arranged or fastened on the force-transmitting surface (2, 3), preferably only in the region of the force-transmitting surface (2, 3) which is situated directly below and/or directly above an EAP stack (1).

10. Method for generating electrical energy from expansion energy on a capacitive basis by displacement of charges, in which the EAP stack (1) of an EAP generator, comprising at least one EAP stack (1) which is arranged between two force-transmitting surfaces (2, 3) arranged parallel to one another, wherein the EAP generator has at least one layer (4, 9) which facilitates the relative displacement between one end of the at least one EAP stack (1) and the force-transmitting surface (2, 3) facing this end, said layer being situated between this end of the at least one EAP stack (1) and the force-transmitting surface (2) facing this end, in that a layer of electroactive polymer is expanded due to an external force effect, is impinged in the state of maximum expansion with electric charges below the breakdown strength, the electroactive polymer is relaxed and the charge is dissipated upon complete relaxation of the layer.

## Revendications

1. Générateur en polymères électroactifs comprenant au moins une pile de polymères électroactifs (1) qui est disposée entre deux surfaces (2,3) transmettant la force, disposées parallèlement l'une à l'autre, **caractérisé en ce que** le générateur en polymères électroactifs comporte une couche (4,9) facilitant le déplacement relatif entre une extrémité d'au moins une pile de polymères électroactifs (1) et la surface transmettant la force (2) orientée vers cette extrémité entre cette extrémité d'au moins une pile de polymères électroactifs (1) et la surface (2) transmettant la force, orientée vers cette extrémité.

2. Générateur en polymères électroactifs selon la revendication 1 **caractérisé en ce que** la couche (4,9) facilitant le déplacement relatif est une couche réduisant le frottement (4).

3. Générateur en polymères électroactifs selon la revendication 2 **caractérisé en ce que** la couche réduisant le frottement (4) est composée d'un corps solide.

4. Générateur en polymères électroactifs selon la revendication 3 **caractérisé en ce que** la couche réduisant le frottement (4) comporte une surface structurée, de préférence en forme de chambres (5 5',5'') qui sont en liaison avec la surface de la couche réduisant le frottement (4).

5. Générateur en polymères électroactifs selon la revendication 3 ou 4 **caractérisé en ce qu'**il comporte en plus un lubrifiant (8) sur la surface de la couche réduisant le frottement (4).

6. Générateur en polymères électroactifs selon la revendication 1 **caractérisé en ce qu'**il comporte une couche intermédiaire (4,9) en tant que couche facilitant le déplacement relatif, ladite couche intermédiaire (4,9) pouvant être fortement déformée.

7. Générateur en polymères électroactifs selon la revendication 6 **caractérisé en ce que** la couche intermédiaire (4,9) est composée d'un matériau homogène, dont les propriétés intrinsèques permettent la déformabilité, ou d'un matériau expansé.

8. Générateur en polymères électroactifs selon l'une quelconque des revendications précédentes **caractérisé en ce qu'**il comporte une couche facilitant le déplacement relatif uniquement à une extrémité d'au moins une pile de polymères électroactifs (1) ou une couche facilitant le déplacement relatif (4,9) à chacune des deux extrémités d'au moins une pile de polymères électroactifs (1).

9. Générateur en polymères électroactifs selon l'une quelconque des revendications précédentes **caractérisé en ce que** la couche facilitant le déplacement relatif (4,9) est disposée ou fixée soit sur la surface de l'extrémité d'une pile de polymères électroactifs (1), soit disposée ou fixée sur la surface transmettant la force (2,3), de préférence uniquement dans la zone de la surface transmettant la force (2,3), qui se situe directement en-dessous et/ou directement au-dessus d'une-pile de polymères électroactifs (1).

10. Procédé destiné à la production d'énergie électrique à partir d'une énergie d'extension sur une base capacitive par déplacement de charges, pour lequel les piles de polymères électroactifs (1) d'un générateur en polymères électroactifs, comprenant au moins une pile de polymères électroactifs (1), qui est disposée entre deux surfaces transmettant la force disposées parallèlement l'une à l'autre (2,3), pour lequel le générateur en polymères électroactifs comporte au moins une couche (4,9) facilitant le déplacement relatif entre une extrémité d'au moins une pile de polymères électroactifs (1) et la surface transmettant la force (2) orientée vers cette extrémité entre cette extrémité d'au moins une pile de polymères électroactifs (1) et la surface (2,3) transmettant la force orientée vers cette extrémité, une couche de polymère électroactif étant dilatée en raison d'un effet de force extérieur, sollicitée à l'état de dilatation maximale avec des charges électriques en-dessous de la force de rupture, le polymère électroactif étant relaxé et la charge étant évacuée à la relaxation complète de la couche.
